**Europäisches Patentamt**

**European Patent Office**

**Office européen des brevets**

(19)

(11) Veröffentlichungsnummer : **0 150 492**
**B1**

(12) **EUROPÄISCHE PATENTSCHRIFT**

(45) Veröffentlichungstag der Patentschrift :
23.03.88

(51) Int. Cl.⁴ : **F 02 D 41/20,** H 03 K 17/64

(21) Anmeldenummer : **84116250.6**

(22) Anmeldetag : **22.12.84**

(54) **Stromregler für elektromagnetische Stellantriebe.**

(30) Priorität : **27.01.84 DE 3402759**

(43) Veröffentlichungstag der Anmeldung :
**07.08.85 Patentblatt 85/32**

(45) Bekanntmachung des Hinweises auf die Patenterteilung : **23.03.88 Patentblatt 88/12**

(84) Benannte Vertragsstaaten :
**DE FR GB IT**

(56) Entgegenhaltungen :
**EP-A- 0 106 743**
**FR-A- 2 269 186**
**FR-A- 2 345 595**
**FR-A- 2 445 893**
**FR-A- 2 458 106**
**US-A- 3 896 346**

(73) Patentinhaber : **ROBERT BOSCH GMBH**
**Postfach 50**
**D-7000 Stuttgart 1 (DE)**

(72) Erfinder : **Andree Reinhold, Dipl.-Ing.MT**
**Im Kaiserfeld 3**
**D-7147 Eberdingen-Hochd. (DE)**

EP 0 150 492 B1

## Beschreibung

### Stand der Technik

Die Erfindung geht aus von einem Stromregler nach der Gattung des Hauptanspruchs. Es sind bereits Leistungsstromregler zur Aussteuerung von Proportionalmagneten bekannt, die als Ventilantriebe eingesetzt werden können. Bei den bekannten Stromreglern wird eine dem Istwert des Erregerstromes proportionale Spannung an einem Meßwiderstand abgegriffen, die in einer Regeleinrichtung mit einem vorgegebenen Sollwert verglichen wird. Die Regeleinrichtung arbeitet im Schaltregelbetrieb, so daß Flußphase und Löschphase abwechselnd auftreten. Entsprechend tritt abwechselnd Erregerstrom und induzierter Strom auf, so daß auch von einem getakteten Steuerstrom gesprochen werden kann. Die bekannten Stromregler haben jedoch den Nachteil, daß mit dem Meßwiderstand nur der Erregerstrom, der während der Flußphase fließt, gemessen und überwacht werden kann. Zur Überwachung der Löschphase ist bei den bekannten Stromreglern ein zusätzlicher Meßwiderstand erforderlich, der vom induzierten Strom durchflossen wird. Die bekannten Stromregler sind durch die Verwendung von zwei Meßwiderständen im Aufbau aufwendig und erfordern arbeitsintensive Abgleichvorgänge.

Aus dem Dokument US-A-3 896 346 ist ein Stromregler für elektromagnetische Stellantriebe bekannt, bei dem die Magnetspule von einem gesteuerten Erregerstrom durchflossen wird. Hierzu wird ein als Schalter arbeitender Transistor in Abhängigkeit vom Erregerstrom betätigt. In Verbindung mit einem zweiten Schalttransistor kann die Versorgungsspannung vollständig abgeschaltet werden, wobei der in der dadurch eingeleiteten Löschphase auftretende induzierte Strom über zwei Dioden zur Spannungsquelle rückgeführt werden kann. Eine Überwachung des induzierten Stroms in der Löschphase ist hier nicht möglich und die Schaltung zur Steuerung des Erregerstroms ist verhältnismäßig aufwendig.

Aus den Dokumenten FR-A-2 345 595 und FR-A-2 458 106 sind weitere Schaltungsanordnungen zur Ansteuerung von Spulen bzw. Magneten bekannt, die jedoch keinen gemeinsamen Meßwiderstand für die Messung des Erregerstroms und des in der Löschphase auftretenden induzierten Stromes besitzen.

### Vorteile der Erfindung

Der erfindungsgemäße Stromregler mit den kennzeichnenden Merkmalen des unabhängigen Anspruchs 1 hat demgegenüber den Vorteil, daß mit nur einem einzigen Meßwiderstand der Erregerstrom in der Flußphase und der induzierte Strom in der Löschphase überwacht werden kann. Die Anordnung mit nur einem Meßwiderstand erfordert einen geringeren Materialaufwand als Stromregler bekannter Bauart. Außerdem kann ein Abgleich auf die jeweiligen Einsatzbedingungen einfacher vorgenommen werden. Es werden zwei Dioden so angeordnet, daß sie während der Flußphase sperren und während der Löschphase eine Rückspeisung des induzierten Stromes bewirken. Der den Meßwiderstand durchfließende Strom fließt während dieser beiden Phasen stets in der gleichen Richtung, wodurch sich die Meßanordnung für den den Magneten durchfließenden Strom verhältnismäßig einfach realisieren läßt. Durch die Rückspeisung des induzierten Stromes während der Löschphase läßt sich die Verlustleistung beträchtlich verringern.

Durch die in den abhängigen Ansprüchen aufgeführten Maßnahmen sind vorteilhafte Weiterbildungen und Verbesserungen des im unabhängigen Anspruch 1 angegebenen Stromreglers möglich.

Bei einer vorteilhaften Weiterbildung des erfindungsgemäßen Stromreglers kann auf einfache Weise eine Überwachungseinrichtung eingesetzt werden, die sowohl während der Flußphase als auch während der Löschphase den Steuerstrom überwacht, um einen möglichen Kurzschluß sofort erkennen zu können. In diesem Fall kann die Überwachungseinrichtung den Steuerstrom begrenzen, so daß eine Zerstörung elektronischer Bauelemente vermieden wird.

### Zeichnung

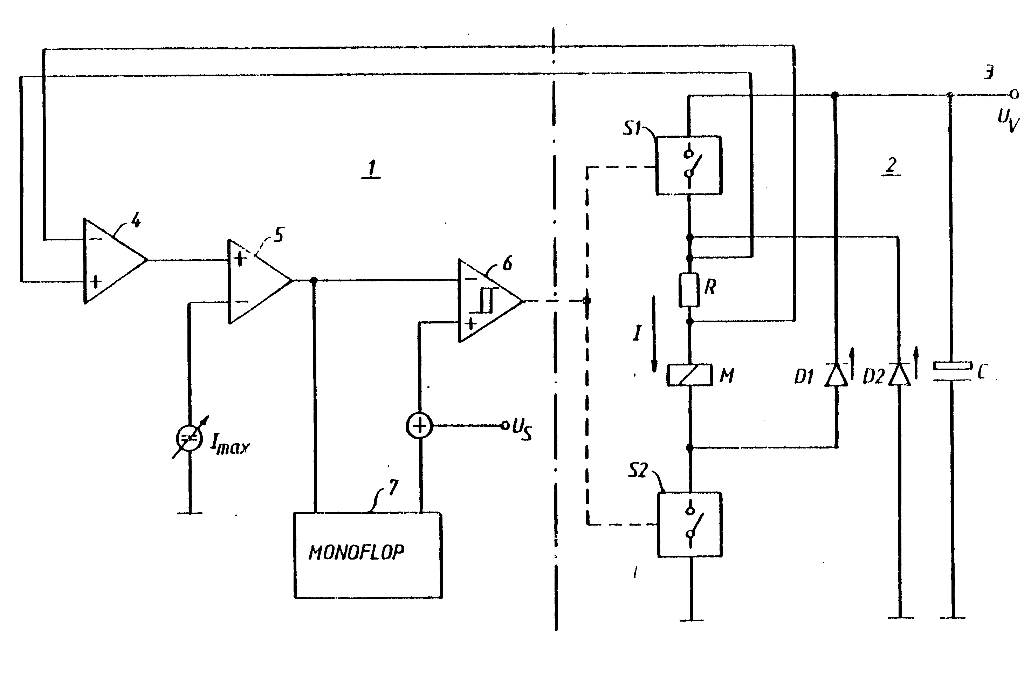

Ein Ausführungsbeispiel der Erfindung ist in der Zeichnung dargestellt und in der nachfolgenden Beschreibung näher erläutert.

### Beschreibung des Ausführungsbeispiels

Die Figur zeigt einen Stromregler der aus einem Regel- und Überwachungsteil 1 und einer Endstufe 2 besteht. Die Endstufe 2 ist über eine Leitung 3 mit der Versorgungsspannung $U_V$ verbunden. Die Versorgungsspannung $U_V$ kann beispielsweise zwischen 20 und 40 Volt liegen.

Die Endstufe 2 stellt eine Leistungsstufe dar, die einen Magneten M speist. Bei diesem Magneten kann es sich insbesondere um einen Proportionalmagneten eines elektromagnetischen Ventilantriebes handeln. Der Magnet M wird mit einem getakteten Steuerstrom I gespeist. Zu diesem Zweck ist ein erster Schalter S1 und ein zweiter Schalter S2 vorgesehen, die gemeinsam mit einer Frequenz zwischen beispielsweise 1 und 3 kHz geschlossen und geöffnet werden. Sind die Schalter S1, S2 geschlossen, fließt der Erregerstrom über die Leitung 3, den Schalter S1, einen nachgeschalteten Meßwiderstand R, den Magneten M und den zweiten Schalter S2 nach Masse. Werden die Schalter dann in die hier dargestellte, offene Stellung verbracht, fließt ein induzierter Strom über zwei Dioden D1 und D2 zur Leitung 3. Bei geschlossenen Schaltern S1, S2 spricht man von der Flußphase, bei geöffneten Schaltern S1, S2 von der Löschphase. Der Meßwiderstand R und der Magnet M werden während beider Phasen in der angegebenen Richtung vom Steuerstrom durchflossen, der sich aus dem Erregerstrom während der Flußphase und dem induzierten Strom während der Löschphase zusammensetzt.

Während der Löschphase wird der durch die Selbstinduktion hervorgerufene induzierte Strom in die Leitung 3 zurückgespeist, die mit einem Kondensator C verbunden ist. Der Stromverlauf während der Löschphase ist durch entsprechende Pfeile neben den Dioden D1, D2 angegeben. In der Flußphase sind diese beiden Dioden gesperrt.

Bei der dargestellten Endstufe 2 handelt es sich um eine Schaltung mit Schnellöschung. Die Schalter S1, S2 werden vorzugsweise durch Leistungsschalttransistoren realisiert, die sich in bekannter Weise durch eine geeignete Ansteuerschaltung betätigen lassen.

Der am Meßwiderstand R auftretende Spannungsabfall stellt eine dem Istwert des Steuerstromes I proportionale Größe dar, die einem im Regel- und Überwachungsteil 1 enthaltenen Differenzverstärker 4 eingangsseitig zugeführt wird. Der Ausgang des Differenzverstärkers 4 ist mit dem positiven Eingang eines Folgeverstärkers 5 verbunden. Am negativen Eingang des Folgeverstärkers 5 wird der maximal zulässige Strom eingestellt. Der Ausgang des Folgeverstärkers 5 ist mit dem negativen Eingang eines Zweipunktreglers 6 und mit einer Überwachungseinrichtung 7 verbunden. Dem positiven Eingang des Zweipunktreglers 6 wird ein Sollwert zugeführt, mit dem der Steuerstrom 1 eingestellt wird. Die Überwachungseinrichtung 7 dient zur Erkennung eines möglichen Kurzschlusses, um die Schalter S1, S2 in einem solchen Störungsfall offen zu halten. Nach Ablauf der Zeitkonstante des Monoflops wird zyklisch abgefragt, ob der Kurzschluß noch vorliegt.

Der Zweipunktregler 6 besitzt eine Schalthysterese. Solange der an seinem negativen Eingang anliegende Istwert kleiner als der an seinem positiven Eingang anliegende Sollwert ist, schaltet der Zweipunktregler 6 die Schalter S1, S2 ein. Der Strom steigt nun solange an, bis der äquivalente Istwert größer als der Sollwert $U_S$ wird. Wird dieser Zustand erreicht, betätigt der Zweipunktregler 6 die Schalter S1, S2 und öffnet diese. Sinkt der Istwert wieder auf einen bestimmten Wert ab, schließt der Zweipunktregler 6 die Schalter S1, S2 wieder. Der Zweipunktregler 6 arbeitet als Komparator mit einer Hysterese, die die Welligkeit des Steuerstromes I bestimmt.

Die Überwachungseinrichtung 7 arbeitet als Monoflop, welches beim Überschreiten eines bestimmten Grenzspitzenstromes die Endstufe 2 für eine definierte Zeit vollständig abschaltet. Dadurch ist der Stromregler gegen Überlast, bedingt durch Masseschluß bzw. Kurzschluß der Magnetanschlüsse, geschützt.

**Patentansprüche**

1. Stromregler für elektromagnetische Stellantriebe, insbesondere für als Ventilantriebe verwendete Proportionalmagnete, der den Istwert des einen Magneten durchfließenden Stromes ermittelt und unter Berücksichtigung eines vorgegebenen Sollwertes einen entsprechenden, getakteten Steuerstrom zur Betätigung des Antriebes liefert, bei dem die Frequenz und/oder das Tastverhältnis zwischen Flußphase und Löschphase die Auslenkung des Stellantriebes bestimmen, dadurch gekennzeichnet, daß der Magnet (M) und ein Meßwiderstand (R) zur Ermittlung des Istwertes in Reihe geschaltet und zwischen zwei Schaltern (S1, S2) angeordnet sind, von denen der eine mit der Versorgungsspannung ($U_V$) und der andere mit Masse verbunden ist und die zur Erzeugung des getakteten Steuerstromes (I) gemeinsam geöffnet und geschlossen werden, und daß der Reihenschaltung, bestehend aus dem Magneten (M), dem Meßwiderstand (R) und dem mit der Versorgungsspannung verbundenen Schalter (S1), eine erste Diode (D1) und der Reihenschaltung, bestehend aus Meßwiderstand (R), Magnet (M) und dem mit Masse verbundenen Schalter (S2), eine zweite Diode (D2) parallel geschaltet ist, die nur für den bei geöffneten Schaltern (S1, S2) auftretenden induzierten Strom durchlässig sind.

2. Stromregler nach Anspruch 1, dadurch gekennzeichnet, daß die beiden Schalter (S1, S2) gemeinsam von einem Zweipunktregler (6) gesteuert werden.

3. Stromregler nach einem der Ansprüche 1 oder 2, dadurch gekennzeichnet, daß eine Überwachungseinrichtung (7) zur Kurzschlußerkennung vorgesehen ist, die sowohl während der Flußphase als auch während der Löschphase den Steuerstrom (I) überwacht.

**Claims**

1. Current controller for electromagnetic actuators, particularly for proportional magnets used as valve driving mechanisms, which determines the actual value of the current flowing through a magnet and, taking into consideration a predetermined setpoint, supplies a corresponding pulsed control current for activating the drive, in which the frequency and/or the duty ratio between flow phase and interruption phase determine the deflection of the actuator, characterized in that the magnet (M) and a sensing resistor (R) for determining the actual value are connected in series and are arranged between two switches (S1, S2), one of which is connected to the supply voltage ($U_V$) and the other one of which is connected to earth and which are jointly opened and closed for generating the pulsed control current (I), and that the series circuit consisting of the magnet (M), the sensing resistor (R) and the switch (S1) connected to the supply voltage, is connected in parallel with a first diode (D1) and the series circuit consisting of sensing resistor (R), magnet (M) and the switch (S2) connected to earth is connected in parallel with a second diode (D2) which are only conductive for the induced current occurring when the switches (S1, S2) are opened.

2. Current controller according to Claim 1, characterized in that the two switches (S1, S2) are jointly controlled by a two-step controller (6).

3. Current controller according to one of Claims 1 or 2, characterized in that a monitoring device (7) for short-circuit detection is provided which monitors the control current (I) both during the flow phase and during the interruption phase.

## Revendications

1. Régulateur de courant pour actuateurs électromagnétiques, en particulier pour des aimants proportionnels utilisés pour des actuateurs de soupape, qui détermine la valeur réelle d'un courant parcourant un aimant et délivre un courant de commande correspondant, en impulsions, en fonction d'une valeur de consigne prédéterminée, pour l'actionnement de l'actuateur, dans lequel la fréquence et/ou l'efficacité impulsionnelle entre phase de flux et phase de désexcitation déterminent la déviation de l'actuateur, caractérisé en ce que l'aimant (M) et une résistance de mesure (R) sont branchés en série, pour la détermination de la valeur réelle et disposés entre deux commutateurs (S1, S2), dont l'un est relié à la tension d'alimentation (Uv) et l'autre est relié à la masse et qui s'ouvrent ensemble, pour produire le courant de commande (I) en impulsion et en ce que le branchement en série, composé de l'aimant (M), de la résistance de mesure (R) et du commutateur (S1) relié avec la tension d'alimentation, est branché en parallèle avec une première diode (D1) et en ce que le branchement en série, composé de la résistance de mesure (R), de l'aimant (M) et du commutateur (S2) relié à la masse, est branché en parallèle avec une deuxième diode (D2), qui ne sont conductrices que pour le courant induit survenant lorsque les deux commutateurs (S1, S2) sont ouverts.

2. Régulateur de courant selon la revendication 1, caractérisé en ce que les deux commutateurs (S1, S2) sont commandés en commun par un régulateur par tout ou rien (6).

3. Régulateur de courant selon l'une des revendications 1 ou 2, caractérisé en ce qu'un dispositif de contrôle (7) est prévu pour l'identification de court-circuit, qui contrôle le courant de commande (I), aussi bien pendant la phase de flux qu'également pendant la phase de désexcitation.